# EUROPEAN PATENT APPLICATION

(11) **EP 3 789 343 A1**
(43) Date of publication of application: **10.03.2021**
(21) Application number: 19195803.2
(22) Date of filing: 06.09.2019
(51) Int. Cl.: B82Y 10/00, H01L 27/06, H01L 29/06, H01L 29/10, H01L 29/66, H01L 29/775, H01L 21/822, H01L 21/8234

(54) **ISOLATED VERTICAL NANOWIRE**

(71) Applicant: Imec VZW, 3001 Leuven (BE)
(72) Inventor: HIBLOT, Gaspard, 3001 Leuven (BE); BAUDOT, Sylvain, 3001 Leuven (BE)
(74) Representative: DenK iP bv

(57) **Abstract**

A method for electrically isolating a vertical nanowire (210) on at least one location in the nanowire. The method comprises providing a substrate (200), forming a vertical nanowire stack on the substrate (200). The stack comprises at least one nanowire section (211) of a first material. A sacrificial section (212) of a second material is provided in the vertical nanowire stack on the at least one location. The second material is selected such that it can be selectively removed with respect to the first material. The method, moreover, comprises creating at least one interconnect (214) to the at least one nanowire section (211) which should be isolated, removing the at least one sacrificial section (212) and replacing it with an isolating section (213) after creating the interconnect (214). In the same way also to vertically spaced vertical nanowires (211) may be isolated.

## Description

### Field of the invention

The invention relates to the field of nanowire semiconductor devices. More specifically it relates to a method for electrically isolating a vertical nanowire.

### Background of the invention

Vertical nanowires are one of the main contenders for decreasing the feature sizes of semiconductor devices.

One important issue that needs to be tackled when creating semiconductor devices with vertical nanowires is the isolation of the nanowires from the substrate. Different methods have been proposed to isolate the nanowires from the substrate, but they are either expensive (SOI substrate) or inefficient (P/N isolation).

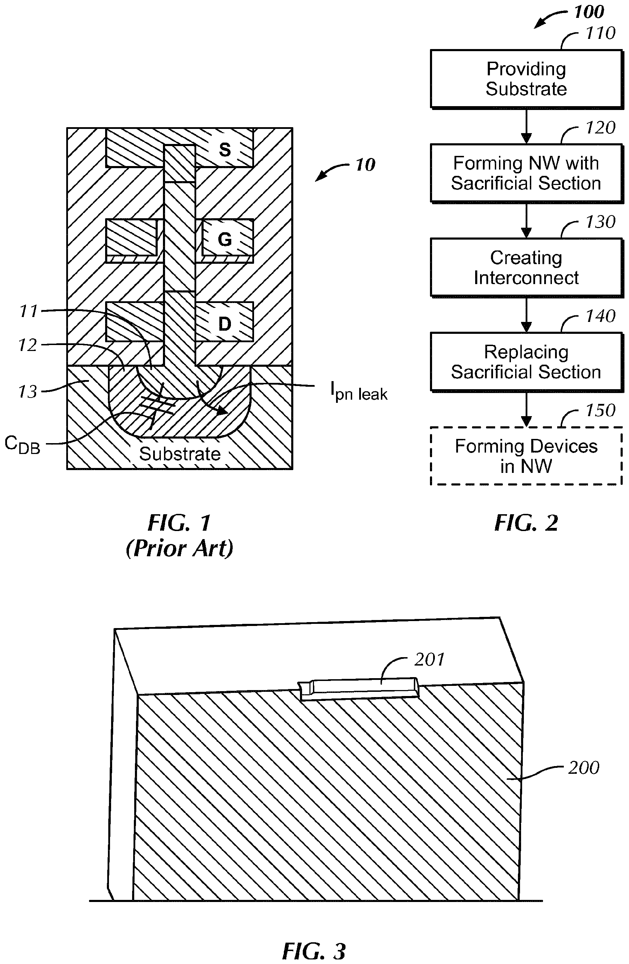

In case of P/N isolation the nanowire bottom junction has a P/N diode interface to the substrate well. This is illustrated in the schematic drawing of FIG. 1. The figure shows a vertical nanowire 10 on which a transistor with source (S), drain (D) and gate (G) is integrated. The figure moreover shows the highly doped drain 11 in a well 12 in the substrate 13. The P/N diode interface between the highly doped drain 11 and the well 12 is detrimental to the junction capacitance and leakage. In addition, the well is floating and requires tap cells to be stabilized. The well processing also adds extra process steps without providing any electrical functionality in case of a vertical nanowire.

There is therefore a need for good methods for electrically isolating a vertical nanowire.

### Summary of the invention

It is an object of embodiments of the present invention to provide a method which allows to isolate a vertical nanowire. The nanowire may be isolated from the substrate or from another nanowire in case of stacked nanowires.

The above objective is accomplished by a method and device according to the present invention.

Embodiments of the present invention relate to a method for electrically isolating a vertical nanowire on at least one location in the nanowire. The method comprises providing a substrate, and forming a vertical nanowire stack on the substrate. The vertical nanowire stack comprises at least one nanowire section of a first material. When forming the vertical nanowire stack at least one sacrificial section of a second material is provided in the vertical nanowire stack. The at least one sacrificial section is provided on the at least one location which needs to be isolated. The second material is selected such that it can be selectively removed with respect to the first material. The method, moreover, comprises creating at least one interconnect to the at least one nanowire section which should be isolated. The method, moreover, comprises removing the at least one sacrificial section and replacing it with an isolating section after creating the interconnect.

It is an advantage of embodiments of the present invention that the sacrificial section is only removed after creating the at least one interconnect with the one or more vertical nanowires. This allows to remove the at least one sacrificial section while the one or more vertical nanowires are kept at their position by the at least one interconnect.

It is an advantage of embodiments of the present invention that a sacrificial section is provided and no complete sacrificial layer which is covering the substrate. Hence, when removing the sacrificial section, not a complete intermediate layer is removed.

In embodiments of the present invention the provided sacrificial section is made of crystalline material.

It is an advantage of embodiments of the present invention that the sacrificial section can be removed after creating the interconnect with the vertical nanowire. Hence, the at least one sacrificial section can be removed early in the process and any thermal budget limitation imposed by the material of the sacrificial section should not be accounted for after removal of the at least one sacrificial section.

After forming the isolating section standard steps may be applied for creating a semiconductor device in the nanowire. This may for example be a transistor. Forming of the gate, spacer, epitaxial growth for creating the transistor may be done after removal of the sacrificial section. Epitaxy may for example be done at temperatures above 600°C. It is, therefore, advantageous that the sacrificial section is already removed and does not impose a thermal budget limitation.

In embodiments of the present invention the method comprises providing a first semiconductor device in the vertical nanowire such that at least one of the one or more isolating sections is located between the first semiconductor device and the substrate.

It is an advantage of embodiments of the present invention that leakage between the first semiconductor device and the substrate is avoided. It is an advantage of embodiments of the present invention that a reduced capacitance between the nanowire and the substrate can be obtained compared to a semiconductor device which is isolated from the substrate by means of a PN junction. It is an advantage of embodiments of the present invention that well processing steps can be skipped.

In embodiments of the present invention high thermal budget steps for creating the semiconductor device are only performed after removing the sacrificial section.

In embodiments of the present invention the method comprises providing a first and a second semiconductor device in the vertical nanowire such that at least one of the one or more isolating sections is located between the first semiconductor device and the second semiconductor device.

It is an advantage of embodiments of the present invention that vertically stacked semiconductor devices can be isolated from each other.

In embodiments of the present invention the one or more semiconductor devices are transistors.

In embodiments of the present invention the first material is silicon.

This may be combined with stacks wherein the second material is silicon-germanium. It is thereby advantageous that SiGe can be selectively removed with respect to Si.

In embodiments of the present invention the first material is silicon-germanium. This may be combined with stacks wherein the second material is silicon. It is thereby advantageous that Si can be selectively removed with respect to SiGe.

In embodiments of the present invention the first material is silicon-germaniums and the second material is germanium. It is an advantage of embodiments of the present invention that Ge can be selectively removed with respect to SiGe.

In embodiments of the present invention the first material is germanium and the second material is silicon-germanium.

In embodiments of the present invention the first material is indium-gallium-arsenide and the second material is indium-phosphide.

In embodiments of the present invention the sacrificial section is provided by epitaxial growth.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a schematic drawing of a prior art vertical nanowire.
FIG. 2 shows a flow chart of an exemplary method in accordance with embodiments of the present invention.
FIG. 3 to FIG. 15 schematically show different stacks when forming a vertical nanowire using an exemplary method in accordance with embodiments of the present invention.
FIG. 16 shows a schematic drawing of an exemplary vertical nanowire obtained using a method in accordance with embodiments of the present invention.
FIG. 17 shows schematic drawings of stacked vertical nanowires, the left drawing having no isolation between the vertical nanowires, and the right drawing having an isolation section, obtained using a method in accordance with embodiments of the present invention, between the vertical nanowires.

Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Embodiments of the present invention relate to a method for isolating a vertical nanowire on at least one location in the nanowire. In embodiments of the present invention this is achieved by providing a sacrificial section in the vertical nanowire stack. The sacrificial section is used to enable the transmission of the crystalline structure to the rest of the nanowire. By removing the sacrificial section the channel can be isolated from the substrate and/or, in a stacked configuration, one vertical nanowire section can be isolated from the other vertical nanowire section. A vertical nanowire section is thereby a part of the nanowire. After applying method steps according to embodiments of the present invention it is, at least on one end, delimited by the isolating section.

In embodiments of the present invention the sacrificial section is removed after providing the local interconnect. Thus, no additional fixture is needed to prevent the nanowire from falling when removing the sacrificial section. Eventually the sacrificial section is replaced by an isolating section. This may for example be an oxide.

A flow chart of an exemplary method in accordance with embodiments of the present invention is illustrated in FIG. 2. The method 100 comprises providing 110 a substrate 200. The substrate may thereby comprise a first material. The method 100, moreover, comprises forming 120 at least one vertical nanowire stack comprising at least one nanowire section 211 of the first material on the substrate. The vertical nanowire stack is provided such that it comprises at least one sacrificial section 212 of a second material in the vertical nanowire stack on at least one location in the nanowire stack. This may be achieved by providing a sacrificial patch of a second material on the substrate or on a stack of layers on the substrate and by growing the nanowire material from this patch, after which the one or more nanowires can be obtained by etching the obtained stack of materials.

The second material is selected such that it can be selectively removed with respect to the first material. This may be achieved by selective etching. The first material may for example be silicon (Si) and the second material may for example be silicon-germanium (SiGe) or vice versa. In embodiments of the present invention the first material may be SiGe and the second material may be germanium (Ge) or vice versa. In yet another embodiment of the present invention the first material may comprise indium gallium arsenide (InGaAs) and the second material may comprise indium phosphide (InP).

Depending on the selected materials different etch processes may be applied. If, for example, the second material (the one being etched) is SiGe or Ge, then typical etch processes are tetrafluoromethane (CF4) plasma and gas phase hydrogen chloride (HCI). If the second material is silicon, then wet etch with tetramethylammonium hydroxide (TMAH), ammonium hydroxide (NH4OH), potassium hydroxide (KOH) can be used, or plasma etch with sulfur (e.g. SF6) can be done. If the second material is InP for InGaAs nanowires, the etch can for example be done with wet HCI.

The method, moreover, comprises creating 130 at least one interconnect 214 to the at least one nanowire section 211 which should be isolated.

The method, moreover, comprises removing 140 the at least one sacrificial section 212 and replacing it with an isolating section 213 after creating the interconnect 214.

The method may be followed by processing steps 150 for forming semiconductor devices in the nanowire sections.

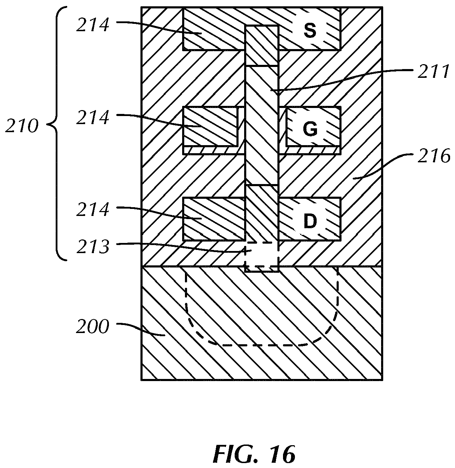

In embodiments of the present invention the method comprises providing a first semiconductor device in the vertical nanowire such that at least one of the one or more isolating sections 213 is located between the first semiconductor device and the substrate 200. A schematic drawing of an exemplary vertical nanowire obtained using such a method is shown in FIG. 16. The figure shows the substrate 200, the vertical nanowire 210 comprising the nanowire section 211, the isolating section 213, and the interconnect 214.

By doing so, leakage between the nanowire and the substrate or leakage between stacked devices on a vertical nanowire can be avoided, and a reduced capacitance between the nanowire and the substrate can be obtained. Moreover, no well, nor a highly doped region in the well in the substrate, as is the case in FIG. 1, to form a P/N junction is required in a vertical nanowire stack obtained using a method in accordance with embodiments of the present invention.

FIG. 3 to FIG. 15 schematically show different stacks obtained using an exemplary method in accordance with embodiments of the present invention.

FIG. 3 shows a schematic drawing of a substrate 200 of the first material. In order to provide a sacrificial patch 203, a local recess 201 is provided in the substrate. This may be achieved by locally etching a cavity in the substrate (e.g. by a straight etch).

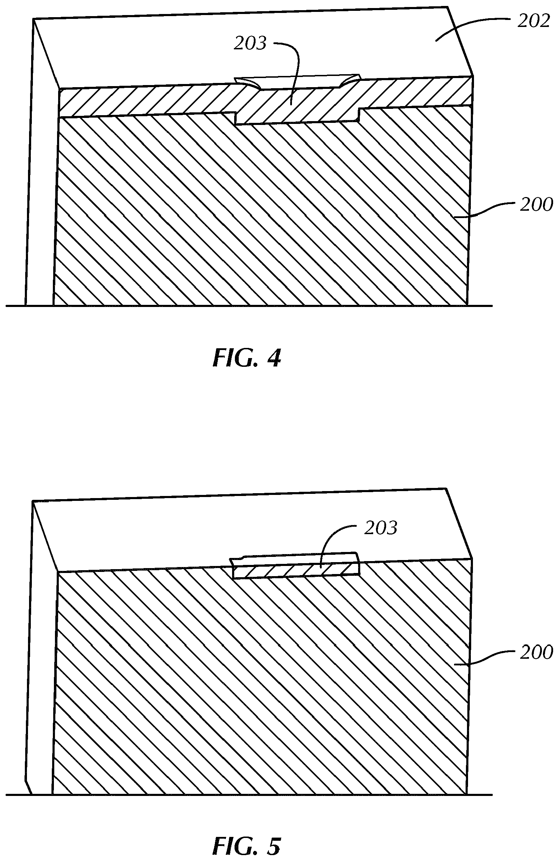

Next a sacrificial epitaxial layer 202 of a second material is provided in the recess (this is illustrated in FIG. 4). This may be achieved by overgrowing the recess. Next the sacrificial layer is planarized such that only the sacrificial patch 203 in the locally etched cavity remains. The planarizing may be done through chemical mechanical polishing.

The invention is not limited to the method described above for providing the sacrificial patch 203. Instead the sacrificial patch may be grown locally, wherein the amount of growing material is controlled. In that case instead of a planarizing step, an additional lithography step is required. In some embodiments of the present invention the sacrificial material is applied locally (limited by the recess, or through local growing). This is advantageous since it prevents lift off when completely removing the sacrificial patch.

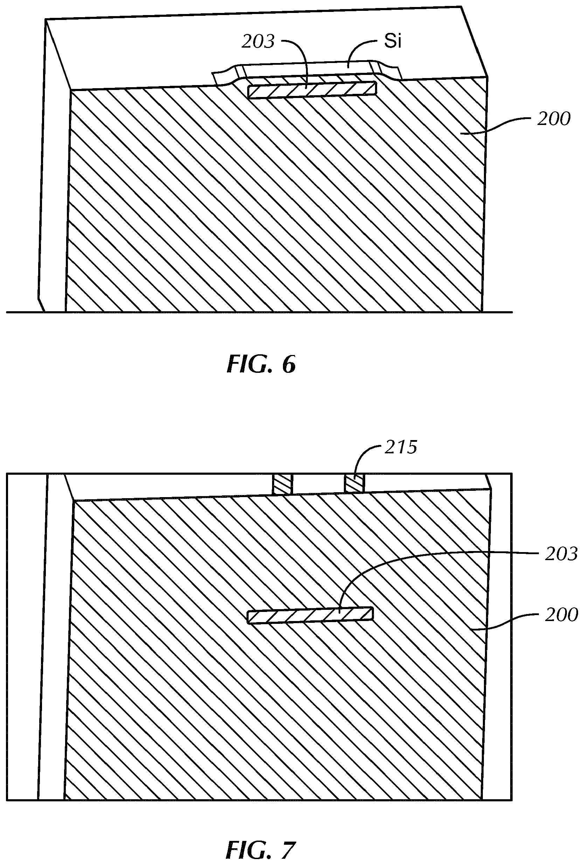

In the exemplary embodiments illustrated by the figures, furthermore, vertical nanowires are formed. This is achieved by growing a layer of the first material on the substrate and on the sacrificial patch 203. This is illustrated in FIG. 6 and FIG. 7. In the example of FIG. 6 the first material is Si, and the second material is SiGe. The SiGe sacrificial patch is used to transmit the crystalline structure to the top of the Si pillar. This intermediate step of Si growth on SiGe illustrates that the Si growth is faster on SiGe than on Si (see FIG. 6), although this difference in growth rates disappears once the SiGe starts to be covered with a certain thickness of Si. In practice, the pre-epitaxial clean may also contribute to a step height difference between Si and SiGe. After epitaxial growth of the first material, the resulting stack may be planarized to remove any height difference. This may be done by chemical mechanical polishing.

Next, a hard mask layer may be deposited. This may for example be a SiN hard mask layer. After which the hard mask layer is patterned. The patterned hard mask layer 215 thereby defines the cross-section of the nanowire pillars. The result is shown in FIG. 7.

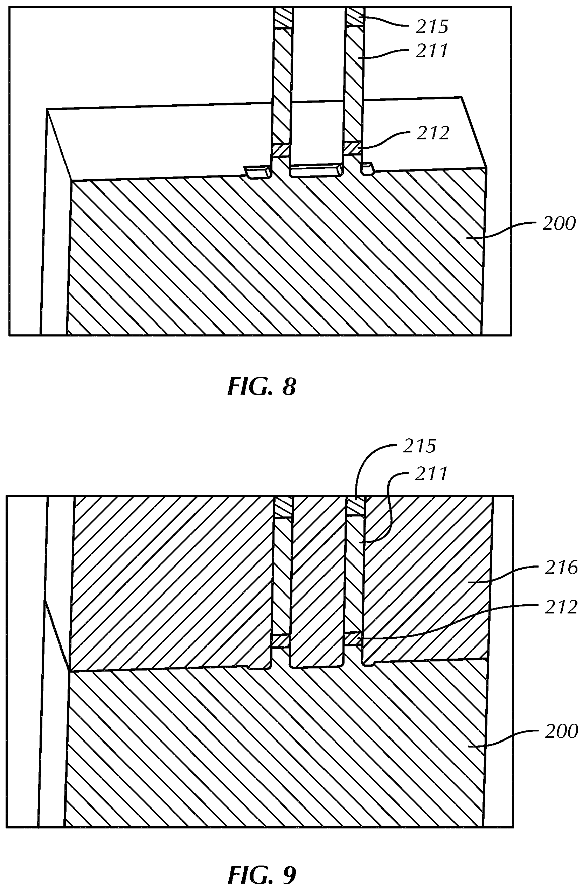

The pattern is transferred in the underlying layers (see FIG. 8). This may be done by straight etching. After the etching step, vertical nanowires are remaining which are comprising a nanowire section 211 and a sacrificial section 212. The sacrificial patch 203 is thereby etched such that only one or more sacrificial sections 212 in the vertical nanowires are remaining.

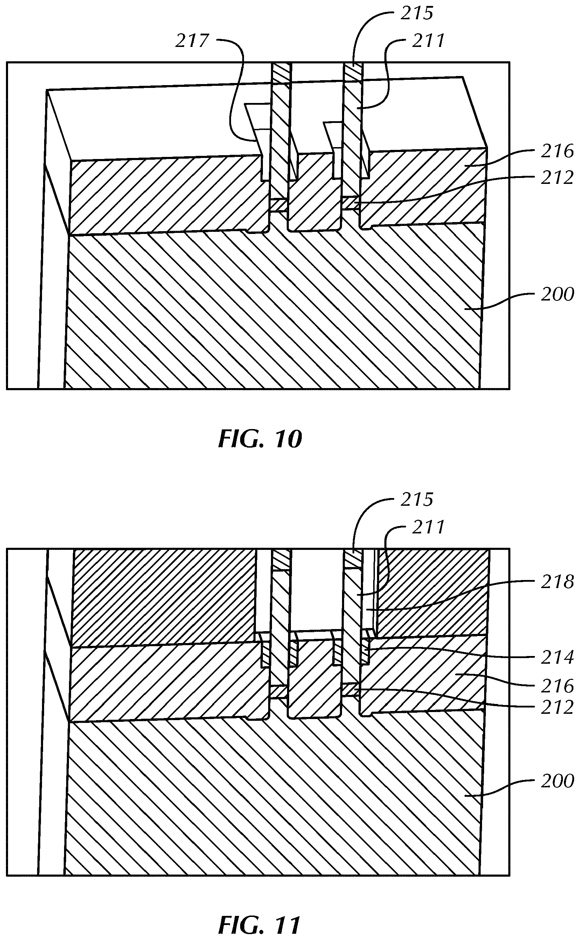

In the exemplary embodiment of the present invention which is illustrated by the figures, the etching step is followed by an SiO2 fill step (see FIG. 9), thus obtaining an SiO2 layer 216 which surrounds the nanowires sections 211. The SiO2 fill step is followed by a recess step and by a patterned etch step (e.g. a M0 bottom patterned etch) to obtain space 217 for creating an interconnect. The stack obtained after the patterned etch step is illustrated in FIG. 10.

To obtain the interconnect 214, the patterned etch step may be followed by a conductive material fill step (e.g. a Tungsten fill step) followed by a recess step.

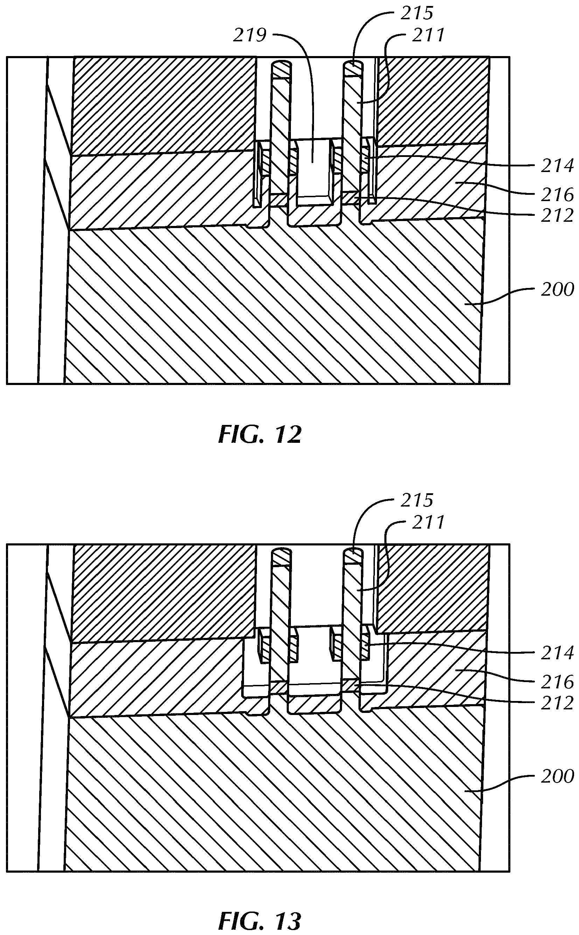

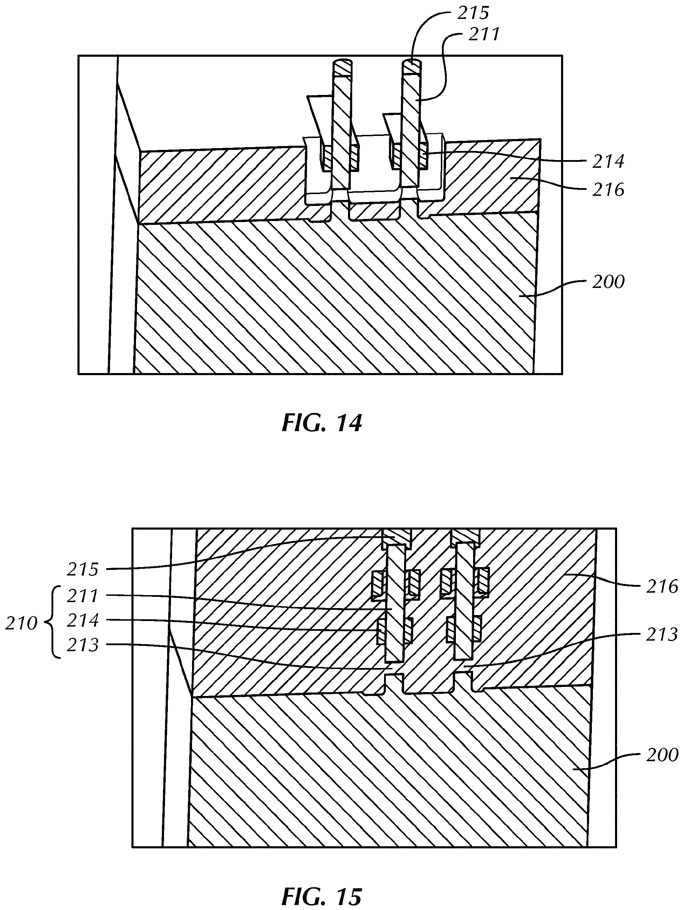

After the at least one vertical nanowire is grown and at least one nanowire section 211 is supported by the (bottom) local interconnect 214, the sacrificial section 212 can be etched selectively. This may be achieved by an oxide localized etch to expose the sidewalls of the vertical nanowire, and then selective removal of the sacrificial section 212. Since the interconnect is holding the nanowire section 211 it is possible to remove the sacrificial section 212 without the nanowire falling down. This may be achieved by depositing a lithography resist 218 which is partly removed to expose the nanowire material. The result thereof is illustrated in FIG. 11. Next a straight SiO2 etch is done. Thus, an anisotropic pattern 219 is etched in the SiO2 layer. The etchant is thereby selected such that it is selective to the interconnect and to the hard mask (meaning that the interconnect and the hard mask are not etched or etched at a much slower rate than the oxide 216). The result thereof is shown in FIG. 12. In this exemplary embodiment this step is followed by an isotropic etch step of the SIO2 to expose the sidewalls of the sacrificial section 212 in the nanowire (FIG. 13). Next the resist 218 may be removed and the sacrificial section 212 may be removed. The latter may be done by a basic etch step. The result is shown in FIG. 14. As can be seen the nanowire sections 211 are kept in their position by the interconnects 214. The sacrificial section 212 is replaced with an isolating section 213. This may be done by an SiO2 fill step.

After removing the sacrificial section 212 and replacing it with an isolating section 213, standard processing steps such as high-K oxide deposition (e.g. HfO₂), gate metal fill (e.g. tungsten), gate metal recess, gate patterning, planar deposit of SiO₂, straight etch for removing the hard mask, Si0₂ fill and recess, trench patterning and planar deposition of a top electrode (e.g. of tungsten), chemical mechanical polishing on tungsten to obtain the top electrode, may be applied for creating the eventual transistors. Thus, a stack as illustrated in FIG. 15 may be obtained. It is thereby advantageous that the thermal budget is not limited by the isolating section as this is already removed.

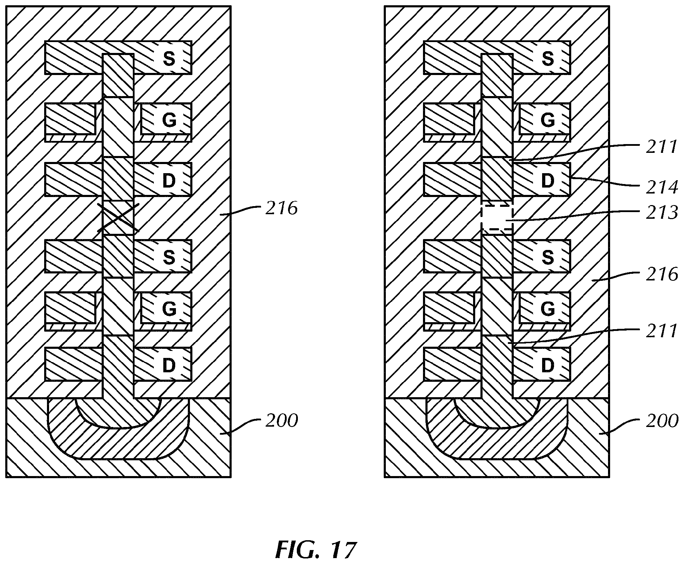

A method in accordance with embodiments of the present invention can also be applied to isolate stacked vertical nanowires. A first and a second semiconductor device may be provided in the vertical nanowire 210 such that at least one of the one or more isolating sections 211 is located between the first semiconductor device and the second semiconductor device. In some embodiments of the present invention the high thermal budget steps for forming these semiconductor devices (those which require a thermal budget which is higher that the thermal budget which can be sustained by the sacrificial layer) are only done after removing the sacrificial material. The left drawing of FIG. 17 shows a stack of a first transistor and a second transistor made of vertical nanowires. The connection between both transistors needs to be severed for stacked vertical nanowire channels. It is an advantage that this can be achieved by providing a sacrificial section between both nanowire sections 211 and by removing the sacrificial section after providing at least one interconnect 214 with the top nanowire section 211, in accordance with embodiments of the present invention. The sacrificial section is replaced by an isolating section 213.
In the examples above the first material was Si and the second material was SiGe. In other embodiments this may, however, be inversed. Thereby SiGe is selected as the first material and Si as the second material.

## Claims

1. A method (100) for electrically isolating a vertical nanowire (210) on at least one location in the nanowire, the method comprising:
- providing (110) a substrate (200),
- forming (120) a vertical nanowire stack, comprising at least one nanowire section (211) of a first material, on the substrate (200), thereby providing at least one sacrificial section (212) of a second material in the vertical nanowire stack on the at least one location, wherein the second material is selected such that it can be selectively removed with respect to the first material,
- creating (130) at least one interconnect (214) to the at least one nanowire section (211) which should be isolated,
- removing (140) the at least one sacrificial section (212) and replacing it with an isolating section (213) after creating the interconnect (214).

2. A method (100) according to claim 1, the method comprising providing a first semiconductor device in the vertical nanowire such that at least one of the one or more isolating sections (213) is located between the first semiconductor device and the substrate (200).

3. A method (100) according to claim 1, the method comprising providing a first and a second semiconductor device in the vertical nanowire (210) such that at least one of the one or more isolating sections (211) is located between the first semiconductor device and the second semiconductor device.

4. A method according to claim 1 or 2 wherein the one or more semiconductor devices are transistors.

5. A method according to any of the previous claims wherein the first material is silicon.

6. A method according to claim 5 wherein the second material is silicon-germanium.

7. A method according to any of the claims 1 to 4 wherein the first material is silicon-germanium.

8. A method according to claim 7 wherein the second material is silicon.

9. A method according to claim 7 wherein the second material is germanium.

10. A method according to any of the claims 1 to 4 wherein the first material is germanium and the second material is silicon-germanium.

11. A method according to any of the claims 1 to 4 wherein the first material is indium-gallium-arsenide and the second material is indium-phosphide.

12. A method according to any of the previous claims wherein the sacrificial section is provided by epitaxial growth.
